# EUROPÄISCHE PATENTSCHRIFT

(11) **EP 1 983 583 B1**
(45) Veröffentlichungstag und Bekanntmachung des Hinweises auf die Patenterteilung: **29.08.2012**
(21) Anmeldenummer: 08006499.1
(22) Anmeldetag: 31.03.2008
(51) Int. Cl.: H01L 39/14, H01L 39/24

(54) **Multifilamentsupraleiter sowie Verfahren zu dessen Herstellung**
Multifilament superconductor and method for its manufacture
Supraconducteur multifilaments et son procédé de fabrication

(30) Priorität: 18.04.2007 DE 102007018268
(43) Veröffentlichungstag der Anmeldung: 22.10.2008
(73) Patentinhaber: European Advanced Superconductors GmbH & Co. KG, 63450 Hanau (DE)
(72) Erfinder: Thöner, Manfred, Dr., 63599 Biebergmünd (DE); Ehser, Horst, 63769 Kahl (DE); Szulczyk, Andreas, 63589 Linsengericht (DE); Auer, Alfred, 63633 Birstein (DE); Abächerli, Vital, Dr., 63526 Erlensee (DE)
(74) Vertreter: Schmuckermaier, Bernhard

(56) Entgegenhaltungen:
- EP-A2- 1 705 721
- WO-A1-2006/011170
- US-A- 4 411 712

## Beschreibung

Die Erfindung betrifft einen Multifilamentsupraleiter, insbesondere einen verstärkten Multifilamentsupraleiter sowie ein Verfahren zu dessen Herstellung.

Ein Beispiel findet sich in der Patentschrift WO2006/011170.

A15-Supraleiter, wie zum Beispiel Nb₃Sn können durch verschiedene Verfahren in Form eines Drahts oder eines Bandes hergestellt werden. Bekannte Verfahren sind das so genannte Bronze-Verfahren, das Jelly-Roll-Verfahren sowie das Pulver-im-Rohr-Verfahren. A15-Supraleiter, die mittels des Pulver-im-Rohr-Verfahrens hergestellt sind, haben den Vorteil, dass sie die höchsten kritischen Stromdichten aufweisen können. Folglich eignen sich die nach dem Pulver-im-Rohr-Verfahren hergestellten Supraleiter für die Anwendung bei hochkompakten und preisgünstigen Magnetsystemen.

Die hohe Stromdichte und die dadurch erzeugten hohen Magnetfelder führen jedoch zu zunehmenden Lorentzkräften in der Magnetwicklung. Diese Lorentzkräfte können die Stromtragfähigkeit des supraleitenden Drahts der Magnetwicklung reduzieren und somit den Einsatzbereich des Pulver-im-Rohr-Drahts begrenzen.

Aufgabe der Erfindung ist es daher, einen mechanisch verstärkten Supraleiter auf Pulver-im-Rohr-Basis anzugeben, der auch für kompakte Magnetsysteme geeignet ist.

Gelöst wird diese Aufgabe durch den Gegenstand der unabhängigen Ansprüche. Vorteilhafte Weiterbildungen der Erfindung ergeben sich aus den davon abhängigen Ansprüchen.

Ein Verfahren zum Herstellen eines verstärkten Multifilamentsupraleiters weist folgende Schritte auf: Mehrere Supraleiterstäbe werden bereitgestellt, die jeweils mindestens einen pulvermetallurgischen Kern aus den Elementen eines metallischen Supraleiters aufweisen. Der Kern ist von einem Innenmantel aus einem nicht-supraleitenden Metall oder einer nicht-supraleitenden Legierung umhüllt. Ein Außenmantel aus einem nicht-supraleitenden Metall oder einer nicht supraleitenden Legierung wird bereitgestellt. Der Außenmantel weist mindestens ein Verstärkungselement aus Tantal oder einer Tantallegierung auf. Die Supraleiterstäbe werden in einem Bündel angeordnet und das Bündel mit dem Außenmantel umhüllt. Zum Erzeugen eines Multifilamentsupraleiters wird das umhüllte Bündel unter Reduzierung des Querschnitts des umhüllten Bündels spanlosverformt. Anschließend wird das verformte Multifilament bei einer Temperatur und einer Dauer geglüht, die ausreichend ist, dass sich in den pulvermetallurgischen Kernen supraleitende Phasen ausbilden.

Als Verstärkungselement ist in diesem Zusammenhang ein Gegenstand zu verstehen, der physiisch getrennt vom Außenmantel ist. Das Verstärkungselement besteht auch aus einer anderen Zusammensetzung als zu der des Außenmantels. Ein Legierungszusatz oder -zusätze des Materials des Außenmantels ist nicht vorgesehen.

Durch dieses Verfahren wird ein mechanisch verstärkter Multifilamentsupraleiter mit einem pulvermetallurgischen Verfahren hergestellt. Das Verstärkungselement des Außenmantels sieht eine mechanische Verstärkung des Multifilaments vor, so dass die Fließgrenze des Multifilaments erhöht wird. Dadurch wird die Stromtragfähigkeit des Multifilaments im Einsatz erhöht, so dass der Einsatzbereich des durch das pulvermetallurgische Verfahren hergestellten Multifilamentsupraleiters erweitert wird.

Die Anordnung des Verstärkungselements als Teil des Außenmantels hat den Vorteil, dass beim herkömmlichen Herstellungsverfahren die mechanische Verstärkung des Multifilaments durch das Bereitstellen des Außenmantels mit mindestens einem Verstärkungselement stattfinden kann. Das Verstärkungselement ist in einer Ausführungsform ohne Legierungszusätze zur mechanischen Verstärkung des Außenmantels vorgesehen.

Der Querschnitt des umhüllten Bündels kann durch herkömmliche spanlose Verfahren reduziert werden, wobei gleichzeitig die Länge vergrößert wird, so dass ein langgestrecktes Multifilament aus den gebündelten Stäben erzeugt wird. Der Querschnitt kann mittels Verfahren wie Ziehen und Hämmern gegebenenfalls mit Zwischenglühungen reduziert werden. Die Filamente des Multifilaments behalten im Wesentlichen die Anordnung der Stäbe des Bündels bei. Im Querschnitt kann das Multifilament eine regelmäßige zwei-dimensionale Matrix von Supraleiterfilamenten aufweisen. Die Packungsdichte wird dadurch erhöht, dass die Stromtragfähigkeit des Multifilaments erhöht wird. In diesem Zusammenhang beschreibt der Querschnitt den Querschnitt senkrecht zur Länge des Multifilaments sowie senkrecht zur Länge der Stäbe.

Ein oder mehrere Verstärkungselemente aus Tantal oder einer Tantallegierung haben dabei den Vorteil, dass sie sich aufgrund ihres günstigen Umformwiderstands mit den anderen Komponenten des Multifilaments integrieren lassen. Dabei sind die anderen Komponenten des Multifilaments die Supraleiterfilamente sowie der Außenmantel. Gleichzeitig ist Tantal ein Metall, das bei typischen Reaktionsbedingungen und bei einer Behandlung zum Bilden der supraleitenden Phase seine hohen mechanischen Eigenschaften aufrechterhält. Ferner weist Tantal auch nach einer Hitzebehandlung bei den typischen Einsatztemperaturen im Bereich von 1.8K bis zu 10K einen extrem hohes E-Modul auf.

Durch das spanlose Verformen des umhüllten Bündels kann ein Multifilament mit der Gestalt eines Drahts oder der Gestalt eines Bandes hergestellt werden.

In einer Ausführungsform wird das Verstärkungselement in Form eines Hüllrohrs bereitgestellt. Diese Form lässt sich einfach im bekannten Herstellungsverfahren einsetzen. In einer weiteren Ausführungsform weist der Außenmantel ein Außenhüllrohr aus einem nicht-supraleitenden Metall oder einer nicht-supraleitenden Legierung und ein Verstärkungshüllrohr aus Tantal oder einer Tantallegierung auf, wobei das Außenhüllrohr das Verstärkungshüllrohr umhüllt. Unter dem Begriff Hüllrohr ist nicht nur ein Rohr mit einem kreisförmigen Querschnitt zu verstehen sondern jede Form von Querschnitt.

Diese Anordnung hat den Vorteil, dass die äußerste Oberfläche des Multifilaments aus einem herkömmlichen Material bestehen kann. Folglich können die herkömmlichen elektrischen Verbindungen zu dem Multifilament hergestellt werden. Beispielsweise bleibt die Außenoberfläche vom Lot benetzbar. Somit wird ein mechanisch verstärkter Multifilamentsupraleiter vorgesehen, der keine zusätzlichen Änderungen bei seiner Verwendung fordert.

Bei einer weiteren Ausführungsform weist der Außenmantel ein Innenhüllrohr und ein Außenhüllrohr aus einem nicht-supraleitenden Metall oder einer nicht-supraleitenden Legierung auf. Das Verstärkungshüllrohr umhüllt das Innenhüllrohr und das Außenhüllrohr umhüllt das Verstärkungshüllrohr. Der Außenmantel besteht bei dieser Ausführungsform aus drei konzentrisch angeordneten Hüllrohren, wobei das Verstärkungshüllrohr zwischen dem Innenhüllrohr und dem Außenhüllrohr angeordnet ist.

Die Innen- und Außenrohre können das gleiche Material oder unterschiedliche Materialen aufweisen. Bei einer Ausführungsform weist der Außenmantel Kupfer auf. Bei weiteren Ausführungsformen weisen die Innen- und Außenrohre Kupfer auf und bestehen im Wesentlichen aus Kupfer.

Diese Anordnung hat den Vorteil, dass das Material der innerste Oberfläche des Außenmantels aus dem herkömmlichen Material bestehen kann. Dies vermeidet ungewünschte chemische Reaktionen zwischen den Supraleiterfilamenten und dem Außenmantel und/oder dem Verstärkungselement. Die Stromtragfähigkeit des Multifilaments wird somit durch das Verstärkungselement nicht beeinträchtigt.

Bei einer Ausführungsform wird der Außenmantel durch hydrostatisches Strangpressen hergestellt. Strangpressen ermöglicht eine gute Verbindung zwischen dem Verstärkungselement und dem Außenmantel bzw. den Innen- und Außenhüllrohren des Außenmantels.

Zum Herstellen des Außenmantels wird in einer Ausführungsform ein Bolzen hydrostatisch stranggepresst und danach der Kern ausgebohrt, um ein Rohr vorzusehen. Dieses Verfahren sieht eine gute Verbindung zwischen dem Material des Verstärkungselements und dem unterschiedlichen Material des Außenmantels vor. Die Supraleiterstäbe als Bündel können in das Bohrloch eingepackt werden.

Die Supraleiterstäbe können jeweils im Wesentlichen die gleiche Querschnittsfläche aufweisen. Dies vereinfacht das Bilden des Bündels und das Bilden einer regelmäßigen zweidimensionalen Matrix. In einer weiteren Ausführungsform werden die Supraleiterstäbe jeweils mit einem sechskantigen Querschnitt vorgesehen. Ein sechskantiger Querschnitt ermöglicht eine dichte Packung der Stäbe in der Matrix, damit die Stromtragfähigkeit des Multifilaments erhöht werden kann.

Der Anteil an Verstärkungselementen kann zwischen ungefähr 10% und ungefähr 25% der Gesamtzahl der Stäbe der Matrix liegen. Dieser Anteil kann an die mechanischen Eigenschaften des Multifilaments, die für ein bestimmtes Magnetsystem erforderlich sind, angepasst werden.

Der Anteil an Verstärkungselementen kann beispielsweise durch die Wandstärke eines einzigen Verstärkungshüllrohrs oder durch die Zahl der Verstärkungshüllrohre eingestellt werden. In einer Ausführungsform weist der Außenmantel mehrere Verstärkungshüllrohre auf, die durch nicht supraleitende Metalle oder Legierungen voneinander getrennt sind. Wenn zum Beispiel zwei Verstärkungshüllrohre vorgesehen sind, weist der Außenmantel insgesamt fünf Rohre auf.

Die mechanischen Eigenschaften des Multifilaments können einfach eingestellt werden, so dass ein Multifilament mit der gewünschten mechanischen Verstärkung vorgesehen werden kann.

Die mechanischen Eigenschaften können somit an die speziellen Anforderungsprofile der Anwendung leicht angepasst werden.

Die pulvermetallurgischen Kerne der Supraleiterstäbe können jeweils die Komponenten eines A15-Supraleiters aufweisen. Die pulvermetallurgischen Kerne der Supraleiterstäbe können auch Pulver aus NbTa, Nb₂Sn und Sn aufweisen, wobei aus diesen Komponenten die supraleitende Phase (Nb,Ta)₃Sn gebildet wird.

Die Supraleiterstäbe können durch ein Pulver-im-Rohr-Verfahren hergestellt werden, wobei Pulver der gewünschten Komponente in einen Kern oder Stab geformt werden, der mit einem Mantel aus einem nicht-supraleitenden Metall oder aus einer nicht-supraleitenden Legierung umhüllt wird. Dieses Vorprodukt wird gegebenenfalls mit Zwischenglühungen verformt, wobei der Querschnitt reduziert und die Länge erhöht wird, um die Supraleiterstäbe herzustellen. Diese Supraleiterstäbe werden zu einem Bündel angeordnet und mit dem Außenmantel umhüllt.

Die supraleitende Phase wird nur nach dem Bündeln und nach den weiteren Verformensschritten zum Herstellen des Multifilaments in den Kernen erzeugt. Zum Bilden der supraleitenden Phasen in den Kernen der Supraleiterfilamente kann eine Glühung des Multifilaments bei 500°C bis 700°C für 2 bis 20 Tage durchgeführt werden.

Der Multifilamentsupraleiter weist einen Kernbereich auf, der mehrere Supraleiterfilamente aufweist. Die Supraleiterfilamente weisen jeweils einen Kern aus einem pulvermetallurgisch hergestellten Supraleiter auf. Der Kernbereich ist von einem Außenmantel aus einem nicht-supraleitenden Metall oder einer nicht-supraleitenden Legierung umhüllt. Der Außenmantel weist mindestens ein Verstärkungselement aus Tantal oder einer Tantallegierung auf.

Wie oben erwähnt ist unter einem Verstärkungselement ein Gegenstand zu verstehen, der getrennt vom Außenmantel ist und aus einer anderen Zusammensetzung als der Außenmantel besteht. Ein Legierungszusatz oder Legierungszusätze des Materials des Außenmantels sind somit mit diesem Begriff ausgeschlossen.

Das Multifilament ist somit auf Grund des Verstärkungselements des Außenmantels mechanisch verstärkt und kann die Gestalt eines Drahts oder die Gestalt eines Bandes aufweisen.

In einer Ausführungsform weist das Verstärkungselement die Form eines Hüllrohrs auf. In einer weiteren Ausführungsform weist der Außenmantel ein Außenhüllrohr aus einem nicht-supraleitenden Metall oder einer nicht-supraleitenden Legierung und ein Verstärkungshüllrohr aus Tantal oder einer Tantallegierung auf, wobei das Außenhüllrohr das Verstärkungshüllrohr umhüllt.

In einer weiteren Ausführungsform weist der Außenmantel ein Innenhüllrohr sowie ein Außenhüllrohr aus einem nicht-supraleitenden Metall oder einer nicht-supraleitenden Legierung auf. Das Verstärkungshüllrohr umhüllt das Innenhüllrohr und das Außenhüllrohr umhüllt das Verstärkungshüllrohr, wobei das Verstärkungshüllrohr zwischen dem Innenhüllrohr und dem Außenhüllrohr angeordnet ist. Die drei Hüllrohre sind in einer Ausführungsform konzentrisch angeordnet.

Der Außenmantel kann Kupfer aufweisen oder im Wesentlichen aus Kupfer bestehen. Wenn ein Innenhüllrohr und ein Außenhüllrohr vorgesehen sind, können diese aus den gleichen Material oder aus unterschiedlichen Materialen bestehen. In einer Ausführungsform weisen das Innenhüllrohr und/oder das Außenhüllrohr Kupfer aus oder bestehen im Wesentlichen aus Kupfer.

Der Anteil an Verstärkungselementen kann eingestellt und an die Anforderung der Anwendung angepasst werden. Der Anteil an Verstärkungselementen kann zwischen ungefähr 10% und ungefähr 25 % des Gesamtmultifilaments liegen. Der Anteil kann zum Beispiel durch die Wandstärke des Verstärkungselements eingestellt werden. Zwei oder mehrere Verstärkungselemente können auch vorgesehen werden und in einer Ausführungsform werden zwei Verstärkungshüllrohre vorgesehen, die konzentrisch im Außenmantel angeordnet werden können. Ein nicht-supraleitendes Metallhüllrohr oder ein nicht-supraleitendes Legierungshüllrohr kann zwischen den jeweiligen Verstärkungshüllrohren angeordnet werden. Diese Anordnung ermöglicht eine Zunahme des Verstärkungsanteils, wenn Verstärkungshüllrohre mit nur einer schmalen Wandstärke vorhanden sind.

Die Kerne der Supraleiterfilamente weisen jeweils die Komponenten eines A15-Supraleiters auf. Die Kerne der Supraleiterfilamente können jeweils die Komponente der (Nb,Ta)₃Sn oder Nb₃Sn oder Nb₃Al oder Nb₃Si oder Nb₃Ge oder V₃Si oder V₃Ga Phase oder die supraleitende (Nb,Ta)₃Sn oder Nb₃Sn oder Nb₃Al oder Nb₃Si oder Nb₃Ge oder V₃Si oder V₃Ga Phase aufweisen.

Die Erfindung wird nun anhand der beiliegenden Figur näher erläutert.

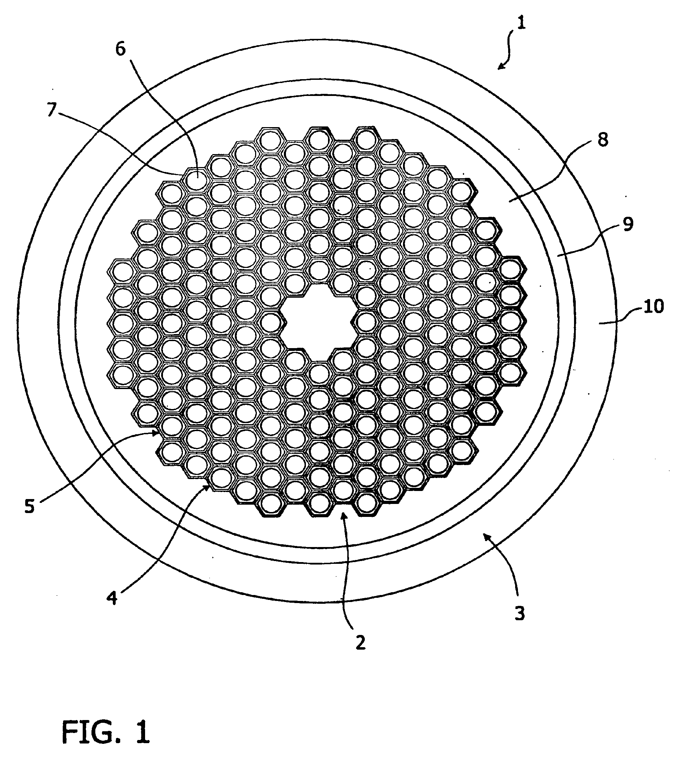

Figur 1 zeigt einen verstärkten Multifilamentsupraleiter.

Figur 1 zeigt den Querschnitt eines mechanisch verstärkten Multifilamentsupraleiters 1 mit einem Kernbereich 2, der von einem Außenmantel 3 umhüllt ist. Der Kernbereich 2 weist 192 Supraleiterfilamente 4 auf. Die Supraleiterfilamente 4 weisen jeweils eine sechskantige Querschnittsfläche auf, die für jedes Filament ungefähr gleich ist. Die Supraleiterfilamente 4 sind zusammengestellt, um eine regelmäßige zwei-dimensionale hexagonale Matrix 5 zu bilden. Die äußeren Supraleiterfilamente 4 der Matrix 5 sind so angeordnet, dass die Außenkante der Matrix 5 einen nahezu kreisförmigen Querschnitt auf weist. In dieser Ausführungsform weist der innere zentrale Bereich des Kernbereichs keine Supraleiterfilamente 4 auf, stattdessen Kupfer.

Die Supraleiterfilamente 4 weisen jeweils einen Kern 6 aus einem pulvermetallurgischen Supraleiter auf. Die supraleitende Phase ist (Nb,Ta)₃Sn. Der Kern 6 ist von einem Innenmantel 7 aus Kupfer umhüllt. Die Supraleiterfilamente 4 wurden durch ein Pulver-im-Rohr-Verfahren hergestellt.

Der Außenmantel 3 besteht in dieser Ausführungsform aus drei konzentrisch angeordneten Hüllrohren. Das innere Hüllrohr 8 besteht im Wesentlichen aus Kupfer und umhüllt den Kernbereich des Multifilaments 1. Das mittlere Hüllrohr 9 besteht im Wesentlichen aus Tantal und sieht die mechanisch Verstärkung des Außenmantels 3 sowie des Gesamtmultifilaments 1 vor. Das äußere Hüllrohr 10 besteht im Wesentlichen aus Kupfer und umhüllt das Verstärkungsrohr 9. Das Verstärkungsrohr 9 ist somit direkt zwischen dem Innenhüllrohr 8 und dem Außenhüllrohr 10 angeordnet.

Ein Verstärkungshüllrohr 9 aus Tantal hat den Vorteil, dass Tantal sich bei der Herstellung gut umformen und verarbeiten lässt, aber nach der Glühung zum Bilden der supraleitenden Phase immer noch ein hohes E-Modul aufweist. Folglich bewirkt Tantal eine mechanische Verstärkung des Endprodukts bzw. des Multifilaments auch beim Einsatz bei niedrigen Temperaturen wie z. B. 4K.

Zum Herstellen des Multifilaments 1 wurde zunächst mehrere Supraleiterstäbe hergestellt. Zum Herstellen der Supraleiterstäbe wurden Pulver der Komponenten der supraleitenden Phase NbTa, Nb₂Sn und Sn zu einem Stab geformt und mit einem Kupfermantel umhüllt. Der Querschnitt wurde durch Ziehen reduziert, um sechskantige Supraleiterstäbe zu formen.

Der Außenmantel 3 wurde durch hydrostatisches Strangpressen eines Bolzens hergestellt. Ein Kupferstab wurde von einem Tantalhüllrohr umschlossen und das Tantalrohr von einem Außenhüllrohr aus Kupfer. Der Verbund wurde hydrostatisch stranggepresst, um die Verbindung zwischen den drei Teilen zu verbessern. Der Kern des Kupferstabs wurde danach ausgebohrt, um den Außenmantel 3 zu bilden.

In einem Ausführungsbeispiel weist der Außenmantel vor dem Verformen zur Herstellung des Multifilaments einen Außendurchmesser von 57.5mm und einen Innendruchmesser von 44,6 mm auf. Das Tantalhüllrohr weist einen Innendurchmesser von 41 mm und folglich eine Wandstärke von 3,6 mm auf. Der Durchmesser des Bohrlochs war 37 mm.

Die Längsseiten der Supraleiterstäbe wurden zusammengestellt und zu einem Bündel angeordnet, das im Querschnitt eine regelmäßige hexagonale Matrix aufweist. Das Bündel wurde mit dem Außenmantel umhüllt und das umhüllte Bündel mittels Ziehen und Zwischenglühungen verformt, damit der Querschnitt reduziert, die Länge erhöht und ein Multifilament 1 hergestellt wird. Die Anordnung der Supraleiterfilamente 4 in der Matrix 5 des hergestellten Multifilaments 1 entspricht der Anordnung der Stäbe im Bündel. Anschließend wurde das Multifilament 1 bei 500°C bis 700°C für 2 bis 20 Tage geglüht, so dass sich in den pulvermetallurgischen Kernen 8 die supraleitende Phase (Nb,Ta)₃Sn aus den Pulver gebildet hat.

In einem weiteren nicht gezeigten Ausführungsbeispiel wurde ein Außenmantel aus zwei konzentrisch angeordneten Hüllrohren hergestellt. Ein Innenhüllrohr aus Tantal wurde von einem Außenhüllrohr aus Kupfer umschlossen. Der Außendurchmesser des Außenhüllrohrs war 65mm, das Bohrloch wies einen Durchmesser von 47 mm bis 48 mm auf und die Länge des Außenmantels war 1000 mm. Dieser Außenmantel wurde als Hüllrohr des Bündels wie oben bereits beschrieben verwendet.

Das Multifilament 1 kann zum Herstellen einer Magnetwicklung verwendet werden. Durch das Verstärkungshüllrohr 6 ist das Multifilament 1 mechanisch verstärkt, so dass die Fließgrenze des Multifilaments 1 erhöht wird. Dies führt zu einer verbesserten Stromtragfähigkeit, da der Einfluss der Lorentzkraft reduziert wird. Dieses mechanisch verstärkte Pulver-im-Rohr-Multifilament kann somit in Magnetsystemen eingesetzt werden, bei denen höhere Lorentzkräfte auftreten, damit auf Grund der höheren Stromtragfähigkeit des Pulver-im-Rohr-Multifilaments die Größe des Magnetes reduziert werden kann. Der Einsatzbereich dieser mechanisch verstärkte Multifilamentsupraleiter mit pulvermetallurgischen Kernen wird somit verbreitert.

### Bezugszeichenliste

- 1: Multifilament
- 2: Kernbereich
- 3: Außenmantel
- 4: Supraleiterfilament
- 5: Matrix
- 6: Kern vom Supraleiterfilament
- 7: Innenmantel vom Supraleiterfilament
- 8: Innenhüllrohr
- 9: Verstärkungshüllrohr
- 10: Außenhüllrohr

## Patentansprüche

1. Verfahren zum Herstellen eines verstärkten Multifilamentsupraleiters (1), das folgende Schritte aufweist:
- Bereitstellen mehrerer Supraleiterstäbe (4), die jeweils mindestens einen pulvermetallurgischen Kern (6) aus den Elementen eines metallischen Supraleiters aufweisen, wobei der Kern (6) von einem Innenmantel (7) aus einem nicht-supraleitenden Metall oder einer nicht-supraleitenden Legierung umhüllt ist,
- Bereitstellen eines Außenmantels (3) aus einem nicht-supraleitenden Metall oder einer nicht supraleitenden Legierung, wobei der Außenmantel (3) mindestens ein Verstärkungselement (9) aus Tantal oder einer Tantallegierung aufweist,
- Anordnen der Supraleiterstäbe (4) zu einem Bündel,
- Umhüllen des Bündels mit dem Außenmantel (3),
- Spannloses Verformen des umhüllten Bündels unter Reduzieren des Querschnitts des umhüllten Bündels zum Erzeugen eines Multifilaments (1),
- Glühen des verformten Multifilaments (1) bei einer Temperatur und einer Dauer, die ausreichend ist, dass sich in den pulvermetallurgischen Kernen (6) supraleitende Phasen ausbilden, **dadurch gekennzeichnet dass** die pulvermetallurgischen Kerne (6) jeweils die Komponenten eines A15-Supraleiters aufweisen.

2. Verfahren nach Anspruch 1,
**dadurch gekennzeichnet, dass**
das Verstärkungselement (9) die Form eines Hüllrohrs aufweist.

3. Verfahren nach einem der Ansprüche 1 oder 2
**dadurch gekennzeichnet, dass**
der Außenmantel (3) ein Außenhüllrohr (10) aus einem nicht-supraleitenden Metall oder einer nicht-supraleitenden Legierung und ein Verstärkungshüllrohr (9) aus Tantal oder einer Tantallegierung aufweist, wobei das Außenhüllrohr (10) das Verstärkungshüllrohr (9) umhüllt.

4. Verfahren nach Anspruch 3,
**dadurch gekennzeichnet, dass**
der Außenmantel (3) ferner ein Innenhüllrohr (8) aus einem nicht-supraleitenden Metall oder einer nicht-supraleitenden Legierung aufweist, wobei das Verstärkungshüllrohr (9) das Innenhüllrohr (8) umhüllt.

5. Verfahren nach einem der vorhergehenden Ansprüche,
**dadurch gekennzeichnet, dass**
der Außenmantel (3) durch hydrostatisches Strangpressen hergestellt wird.

6. Verfahren nach Anspruch 5,
**dadurch gekennzeichnet, dass**
zum Herstellen des Außenmantels (3) ein Bolzen hydrostatisch stranggepresst wird und danach der Kern ausgebohrt wird.

7. Verfahren nach einem der vorhergehenden Ansprüche,
**dadurch gekennzeichnet, dass**
der Außenmantel (3) Kupfer aufweist.

8. Verfahren nach einem der vorhergehenden Ansprüche,
**dadurch gekennzeichnet, dass**
der Anteil an Verstärkungselement (9) zwischen ungefähr 10% und ungefähr 25 % des Gesamtmultifilaments (1) liegt.

9. Verfahren nach einem der vorhergehenden Ansprüche,
**dadurch gekennzeichnet, dass**
die pulvermetallurgischen Kerne (6) der Supraleiterstäbe (4) jeweils Pulver aus NbTa, Nb₂Sn und Sn aufweisen.

10. Verfahren nach einem der vorhergehenden Ansprüche,
**dadurch gekennzeichnet, dass**
die Glühung bei 500°C bis 700°C für 2 bis 20 Tage durchgeführt wird.

11. Verfahren nach einem der vorhergehenden Ansprüche,
**dadurch gekennzeichnet, dass**
die Supraleiterstäbe (4) durch ein Pulver-im-Rohr-Verfahren hergestellt werden.

12. Verfahren nach einem der vorhergehenden Ansprüche,
**dadurch gekennzeichnet, dass**
durch das spanlose Verformen des umhüllten Bündels das Multifilament (1) in Gestalt eines Drahts oder in Gestalt eines Bandes erzeugt wird.

13. Multifilamentsupraleiter (1) mit einem Kernbereich (2), der mehrere Supraleiterfilamente (4) aufweist, wobei die Supraleiterfilamente (4) jeweils einen Kern (6) aus einem pulvermetallurgischen hergestellten Supraleiter aufweisen, wobei der Kernbereich (2) von einem Außenmantel (3) aus einem nicht-supraleitenden Metall oder einer nicht-supraleitenden Legierung umhüllt ist, wobei der Außenmantel (3) mindestens ein Verstärkungselement (9) aus Tantal oder einer Tantallegierung aufweist, und **dadurch gekennzeichnet dass** die pulvermetallurgischen Kerne (6) jeweils die Komponenten eines A15-Supraleiters aufweisen.

14. Multifilamentsupraleiter (1) nach Anspruch 13,
**dadurch gekennzeichnet, dass**
das Multifilament (1) die Gestalt eines Drahts oder eines Bandes aufweist.

15. Multifilamentsupraleiter (1) nach einem der Ansprüche 13 oder 14,
**dadurch gekennzeichnet, dass**
das Verstärkungselement (9) die Form eines Hüllrohrs aufweist.

16. Multifilamentsupraleiter (1) nach einem der Ansprüche 13 bis 15,
**dadurch gekennzeichnet, dass**
der Außenmantel (3) ein Außenhüllrohr (10) aus einem nicht-supraleitenden Metall oder einer nicht-supraleitenden Legierung und ein Verstärkungshüllrohr (9) aus Tantal oder einer Tantallegierung aufweist, wobei das Außenhüllrohr (10) das Verstärkungshüllrohr (9) umhüllt.

17. Multifilamentsupraleiter (1) nach Anspruch 16,
**dadurch gekennzeichnet, dass**
der Außenmantel (3) ferner ein Innenhüllrohr (8) aus einem nicht-supraleitenden Metall oder einer nicht-supraleitenden Legierung aufweist, wobei das Verstärkungshüllrohr (9) das Innenhüllrohr (8) umhüllt.

18. Multifilamentsupraleiter (1) nach einem der Ansprüche 13 bis 17,
**dadurch gekennzeichnet, dass**
der Außenmantel (3) Kupfer aufweist.

19. Multifilamentsupraleiter (1) nach einem der Ansprüche 13 bis 18,
**dadurch gekennzeichnet, dass**
der Anteil an Verstärkungselement (9) zwischen ungefähr 10% und ungefähr 25 % des Gesamtmultifilaments (1) liegt.

20. Multifilamentsupraleiter (1) nach einem der Ansprüche 13 bis 19,
**dadurch gekennzeichnet, dass**
die Kerne (6) der Supraleiterfilamente (4) jeweils (Nb, Ta)₃Sn oder Nb₃Sn oder Nb₃Al oder Nb₃Si oder Nb₃Ge oder V₃Si oder V₃Ga aufweisen.

## Claims

1. A method of manufacturing a reinforced multifilament superconductor (1) which includes the following steps:
- providing a plurality of superconductor rods (4) which each have at least one powder metallurgical core (6) of the elements of a metallic superconductor, wherein the core (6) is surrounded by an inner shell (7) of a non-superconducting metal or a non-superconducting alloy,
- providing an outer shell (3) of a non-superconducting metal or a non-superconducting alloy, wherein the outer shell (3) includes at least one reinforcing element (9) of tantalum or a tantalum alloy,
- forming the superconductor rods (4) into a bundle,
- encasing the bundle with the outer shell (3),
- deforming the encased bundle in a non-machining manner whilst reducing the cross sectional area of the encased bundle to produce a multifilament (1),
- annealing the deformed multifilament (1) at a temperature and for a duration which is sufficient for superconductive phases to form in the powder metallurgical cores (6),
**Characterised in that** the power metallurgical cores (6) each have the components of an A15 superconductor.

2. A method as claimed in claim 1, **characterised in that** the reinforcing element (9) has the form of a cladding tube.

3. A method as claimed in one of claims 1 or 2, **characterised in that** the outer shell (3) includes an outer cladding tube (10) of a non-superconductive metal or a non-superconductive alloy and a reinforcing cladding tube (9) of tantalum or a tantalum alloy, wherein the outer cladding tube (10) surrounds the reinforcing cladding tube (9).

4. A method as claimed in claim 3, **characterised in that** the outer shell (3) further includes an inner cladding tube (8) of a non-superconductive metal or a non-superconductive alloy, wherein the reinforcing cladding tube (9) surrounds the inner cladding tube (8).

5. A method as claimed in one of the preceding claims, **characterised in that** the outer shell (3) is produced by hydrostatic extrusion moulding.

6. A method as claimed in claim 5, **characterised in that** in order to produce the outer shell (5) a rod is hydrostatically extrusion moulded and thereafter the core is bored out.

7. A method as claimed in one of the preceding claims, **characterised in that** the outer shell (3) includes copper (8).

8. A method as claimed in one of the preceding claims, **characterised in that** the proportion of the reinforcing element (9) in the overall multifilament (1) is between about 10% and about 25%.

9. A method as claimed in one of the preceding claims, **characterised in that** the powder metallurgical cores (9) of the superconductor rods (4) each include powder of NbTa, Nb₂Sn and Sn.

10. A method as claimed in one of the proceeding claims, **characterised in that** the annealing process is conducted at 500°C to 700°C for 2 to 20 days.

11. A method as claimed in one of the preceding claims, **characterised in that** the superconductor rods are produced by a powder-in-tube process.

12. A method as claimed in one of the preceding claims, **characterised in that** the multifilament is produced in the shape of a wire or in the shape of a strip by the non-machine deformation of the sheathed bundle.

13. A multifilament superconductor (1) with a core region (2) which includes a plurality of superconductor filaments (4), wherein the superconductor filaments (4) each include a core (6) consisting of a superconductor produced by a powder metallurgical method, wherein the core region (2) is surrounded by an outer shell (3) of a non-superconductive metal or a non-superconductive alloy, wherein the outer shell (3) includes at least one reinforcing element (9) or tantalum or a tantalum alloy and **characterised in that** the powder metallurgical cores (6) each include the components of an A15 superconductor.

14. A multifilament superconductor (1) as claimed in claim 13, **characterised in that** the multifilament (1) has the shape of a wire or a strip.

15. A multifilament superconductor (1) as claimed in one of claims 13 or 14, **characterised in that** the reinforcing element (9) has the form of a cladding tube.

16. A multifilament superconductor (1) as claimed in one of claims 13 to 15, **characterised in that** the outer shell (3) surrounds an outer cladding tube (10) of a non-superconductive metal or a non-superconductive alloy and a reinforcing cladding tube (9) of tantalum or a tantalum alloy, wherein the outer cladding tube (10) surrounds the reinforcing cladding tube (9).

17. A multifilament superconductor (1) as claimed in claim 16, **characterised in that** the outer shell (3) further includes an inner cladding tube (8) of a non-superconductive metal or an non-superconductive alloy, wherein the reinforcing cladding tube (9) surrounds the inner cladding tube (8).

18. A multifilament superconductor (1) as claimed in one of claims 13 to 17, **characterised in that** the outer shell (3) includes copper.

19. A multifilament superconductor (1) as claimed in one of claims 13 to 18, **characterised in that** the proportion of the reinforcing element (9) in the total multifilament (1) is between about 10% and about 25%.

20. A multifilament superconductor (1) as claimed in one of claims 13 to 19, **characterised in that** the cores (6) of the superconductor filaments (4) each include (Nb, Ta) ₃Sn or Nb₃Sn or Nb₃Al or Nb₃Si or Nb₃Ge or V₃Si or V₃Ga.

## Revendications

1. Procédé d'obtention d'un supraconducteur multifilament (1) renforcé comprenant les étapes consistant à :
- se procurer plusieurs barreaux supraconducteurs (4) comportant chacun au moins un noyau (6) obtenu par la métallurgie des poudres à partir des éléments d'un supraconducteur métallique, le noyau (6) étant entouré d'une enveloppe interne (7) en un métal non supraconducteur ou en un alliage non supraconducteur,
- se procurer une enveloppe externe (3) en un métal non supraconducteur ou en un alliage non supraconducteur, cette enveloppe externe (3) renfermant au moins un élément de renforcement (9) en tantale ou en un alliage de tantale,
- arranger les barreaux supraconducteurs (4) en un faisceau,
- entourer le faisceau par l'enveloppe externe (3),
- mettre en forme sans enlèvement de matière le faisceau enveloppé, en réduisant la section de ce faisceau pour obtenir un multifilament (1),
- calciner le multifilament (1) mis en forme à une température et pendant une durée suffisante pour que des phases supraconductrices se forment, dans les noyaux (6) obtenus par la métallurgie des poudres,
**caractérisé en ce que**
les noyaux (6) obtenus par la métallurgie des poudres, renferment respectivement les constituants d'un supraconducteur A 15.

2. Procédé conforme à la revendication 1,
**caractérisé en ce que**
l'élément de renforcement (9) présente la forme d'un tube enveloppe.

3. Procédé conforme à l'une des revendications 1 et 2,
**caractérisé en ce que**
l'enveloppe externe (3) renferme un tube enveloppe externe (10) en un métal non supraconducteur ou en un alliage non supraconducteur et un tube enveloppe de renforcement (9) en tantale ou en un alliage de tantale, le tube enveloppe externe (10) entourant le tube enveloppe de renforcement (9).

4. Procédé conforme à la revendication 3,
**caractérisé en ce que**
l'enveloppe externe (3) comporte en outre un tube enveloppe interne (8) en un métal non supraconducteur ou en un alliage non supraconducteur, le tube enveloppe de renforcement (9) entourant le tube enveloppe interne (8).

5. Procédé conforme à l'une des revendications précédentes,
**caractérisé en ce que**
l'enveloppe externe (3) est obtenue par extrusion hydrostatique.

6. Procédé conforme à la revendication 5,
**caractérisé en ce que**
pour obtenir l'enveloppe externe (3), on soumet une billette à une extrusion hydrostatique puis, on évide le noyau.

7. Procédé conforme à l'une des revendications précédentes,
**caractérisé en ce que**
l'enveloppe externe (3) renferme du cuivre.

8. Procédé conforme à l'une des revendications précédentes,
**caractérisé en ce que**
la proportion d'élément de renforcement (9) est située entre environ 10 % et environ 25 % de la totalité du multifilament (1).

9. Procédé conforme à l'une des revendications précédentes,
**caractérisé en ce que**
les noyaux (6) obtenus par la métallurgie des poudres des barreaux supraconducteurs (4) renferment respectivement de la poudre de NbTa, Nb₂Sn et Sn.

10. Procédé conforme à l'une des revendications précédentes,
**caractérisé en ce que**
la calcination est effectuée à une température de 500°C à 700°C pendant 2 à 20 jours.

11. Procédé conforme à l'une des revendications précédentes,
**caractérisé en ce que**
les barreaux supraconducteurs (4) sont obtenus par un procédé poudre en tube.

12. Procédé conforme à l'une des revendications précédentes,
**caractérisé en ce que**
le procédé de mise en forme sans enlèvement de matière du faisceau enveloppé, permet d'obtenir le multifilament (1) sous la forme d'un fil ou sous la forme d'une bande.

13. Supraconducteur multifilament (1) comprenant une zone de noyau (2) qui renferme plusieurs filaments supraconducteurs (4), ces filaments supraconducteurs comportant respectivement un noyau (6) en un supraconducteur obtenu par la métallurgie des poudres, la zone de noyau (2) étant entourée par une enveloppe externe (3) en un métal non supraconducteur ou en un alliage non supraconducteur, et l'enveloppe externe (3) renfermant au moins un élément de renforcement (9) en tantale ou en un alliage de tantale,
**caractérisé en ce que**
les noyaux (6) obtenus par la métallurgie des poudres renferment respectivement les composants d'un supraconducteur A15.

14. Supraconducteur multifilament (1) conforme à la revendication 13,
**caractérisé en ce que**
le multifilament (1) a la configuration d'un fil ou d'une bande.

15. Supraconducteur multifilament (1) conforme à l'une des revendications 13 ou 14,
**caractérisé en ce que**
l'élément de renforcement (9) présente la forme d'un tube enveloppe.

16. Supraconducteur multifilament (1) conforme à l'une des revendications 13 à 15,
**caractérisé en ce que**
l'enveloppe externe (3) renferme un tube enveloppe externe (10) en un métal non supraconducteur ou en un alliage non supraconducteur et un tube enveloppe de renforcement (9) en tantale ou en un alliage de tantale, le tube enveloppe externe (10) entourant le tube enveloppe de renforcement (9).

17. Supraconducteur multifilament (1) conforme à la revendication 16,
**caractérisé en ce que**
l'enveloppe externe (3) renferme en outre un tube enveloppe interne (8) en un métal non supraconducteur ou en un alliage non supraconducteur, le tube enveloppe de renforcement (9) entourant le tube enveloppe interne (8).

18. Supraconducteur multifilament (1) conforme à l'une des revendications 13 à 17,
**caractérisé en ce que**
l'enveloppe externe (3) renferme du cuivre.

19. Supraconducteur multifilament (1) conforme à l'une des revendications 13 à 18,
**caractérisé en ce que**
la proportion d'élément de renforcement (9) est située entre environ 10 % et environ 20 % de la totalité du multifilament (1).

20. Supraconducteur multifilament (1) conforme à l'une des revendications 13 à 19,
**caractérisé en ce que**
les noyaux (6) des filaments supraconducteurs (4) renferment respectivement (Nb, Ta)₃Sn ou Nb₃Sn ou Nb₃Al ou Nb₃Si ou Nb₃Ge ou V₃Si ou V₃Ga.
